Europäisches Patentamt
European Patent Office
Office européen des brevets

(19)

(11) Publication number: **0 313 993 A1**

(12) **EUROPEAN PATENT APPLICATION**

(21) Application number: 88117505.3

(51) Int. Cl.4: H01L 21/00 , G03F 7/08

(22) Date of filing: 20.10.88

(30) Priority: 20.10.87 JP 264490/87
20.10.87 JP 264491/87
23.10.87 JP 266591/87
20.07.88 JP 179176/88

(43) Date of publication of application:
03.05.89 Bulletin 89/18

(84) Designated Contracting States:
DE FR GB

(71) Applicant: Matsushita Electric Industrial Co., Ltd.
1006, Oaza Kadoma
Kadoma-shi Osaka-fu, 571(JP)

(72) Inventor: Endo, Masayuki
782, Kurodoricho
Izumi-shi(JP)
Inventor: Sasago, Masaru
1-3-14, Kohoku-1-chome
Hirakata-shi(JP)
Inventor: Ueno, Atushi
52-9, Nagao Motomachi-7-chome
Hirakata-shi(JP)
Inventor: Nomura, Noboru
35, Fukakusa Nakanoshimacho
Fushimi-ku Kyoto(JP)
Inventor: Ogawa, Kazufumi
30-5, Higashinakaburi-1-chome
Hirakata-shi(JP)

(74) Representative: Patentanwälte Leinweber & Zimmermann
Rosental 7/II Aufg.
D-8000 München 2(DE)

(54) **Pattern forming method.**

(57) The present invention provides a pattern forming method which comprises forming a material decreasing its ultraviolet transmittance upon exposure to far ultraviolet ray on a ultraviolet-sensitive positive type resist, selectively exposing it to a far ultraviolet ray, subsequently exposing its whole area to ultraviolet ray, and thereafter removing the film of said material and developing the resist. Alternatively, the material may also be a material increasing its ultraviolet transmittance upon exposure to far ultraviolet ray. In any of these cases, the film of said material functions as a contact mask upon the whole area exposure to ultraviolet ray, owing to which a pattern of good shape can be formed. As a substance decreasing its ultraviolet transmittance, the film of the material can contain an azide compound, a spiropyran compound or a melamine compound, for example. As a substance increasing its transmittance, the film of the material can contain a diazo compound or a nitron compound, for example. Further, a similarly good pattern can be obtained by using an acridine derivative as the material film and similarly combining ArF excimer laser and far ultraviolet ray, too.

FIG. 1(d)

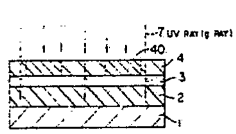


EP 0 313 993 A1

Xerox Copy Centre

# PATTERN FORMING METHOD

## BACKGROUND OF THE INVENTION

The present invention relates to a method for forming fine patterns using excimer laser, in the production process of semiconductors.

As a lithographic technique for the production of semiconductors, the use of excimer laser as a light source has been proposed (for example, V. Pol et al., Proc. of SPIE, 633, 6 (1986)). Though excimer laser lighography is expected to provide a high resolving power owing to the shortness of wavelength used therein, no appropriate resist usable in this method has yet been discovered until today, so that this method cannot give a pattern of good shape at the present stage.

Figure 5 illustrates the prior pattern forming method using excimer laser. Thus, a far ultraviolet positive resist MP 2400 (manufactured by Shipley Co.) is coated, up to a thickness of 1.2 µm, on substrate 1 which has previously been made hydrophobic, and it is pre-baked at 90 °C for 2 minutes to obtain a resist film 17 (Figure 5a). Then, it is selectively irradiated with 150 mJ/cm$^2$ of KrF (248 nm) excimer laser 6 through intermediation of mask 5 (NA. 0.35) (Figure 5b) and developed with MP 2401 20% alkaline developing solution to form a pattern (Figure 5c).

This prior method is disadvantageous in that, due to the great absorption of laser at the resist surface, even the unexposed area is attacked by the excimer laser, so that the resulting pattern 17A (0.4 µm) shows so great a film loss as 40 to 50% and its shape is close to triangle and not good. If such a defective pattern is used in the production of semiconductors, the yield of element is so low as to make an important trouble.

Next, referring to Figure 6, a prior method for forming resist pattern will be mentioned below. Thus, ultraviolet resist MP 1400 (manufactured by Shipley Co.) is rotationally coated onto substrate 1 and pre-baked to obtain resist film 8 having a thickness of 1.2 µm (Figure 6a). Then, resist 8 is selectively exposed to KrF excimer laser 6 (248 nm) through intermediation of mask 5 (Figure 6b). Finally, it is developed with usual alkaline developing solution (MF-314, manufactured by Shipley Co.) to obtain resist pattern 8B (Figure 6c).

However, as has been mentioned above, light cannot reach the deep part of MP 1400, and therefore the resulting resist pattern 2b is not good in shape. That is to say, in the prior resists showing a great light absorption at their surface such as MP 1400, it is impossible to obtain a fine pattern of good shape when exposure is carried out with a short wavelength light source such as KrF 248 nm excimer laser.

If ArF (193 nm) laser having the shortest wave-length among the excimer lasers is used, it may be possible to obtain a fine pattern. However, none of the etching- resistant positive resists available today is suitable for ArF exposure. That is, due to the great absorption of the resist in the far ultraviolet region, the light cannot reach the deep areas of resist, so that the resulting pattern becomes triangular and makes trouble in the subsequent steps.

Figure 7 illustrates the prior pattern forming method by showing a sectional view of semiconductor device. Thus, a positive type resist AZ 2400 is rotationally coated onto substrate 1 and pre-baked to obtain resist 13 having a thickness of 1.2 µm (Figure 7a). Then, resist 13 is selectively exposed to ArF excimer laser 16 (193 nm) through intermediation of mask 5 (Figure 7b). Finally, it is subjected to usual alkaline development to obtain resist pattern 13B having a thickness of 0.4 µm (Figure 7c).

However, as has been mentioned above, in prior positive type resist AZ 2400, light cannot reach the deep part of resist, so that resist pattern 3B is deteriorated in its shape. As above, in the prior resists showing great surface absoprtion of light such as AZ 2400, it is impossible to obtain a fine pattern of good shape when a short wavelength light such as ArF 193 nm excimer laser is used as light source of exposure.

## SUMMARY OF THE INVENTION

The object of the present invention consists in solving the problem of defective pattern in the prior pattern forming methods using KrF or ArF excimer laser.

According to the invention, a fine pattern of good shape is formed by the use of excimer laser, and the invention is constructed from the following means.

Thus, the invention provides a pattern forming method which comprises forming an ultraviolet resist as an under layer, a water-soluble layer as an intermediate layer (a layer for preventing the mutual contamination between the upper and under layers) and a layer of a material decreasing its ultraviolet

transmittance upon exposure to far ultraviolet ray as an upper layer, followed by selectively irradiating the product with an excimer laser and thereafter irradiating its whole area with ultraviolet ray, removing the intermediate and upper layers, and then developing the under layer.

According to the pattern forming method of the present invention, the upper layer, i.e. a film of a material decreasing its ultraviolet transmittance upon exposure to far ultraviolet ray, decreases its ultraviolet transmittance of exposed part when selectively irradiated with excimer laser and transmits no ultraviolet rays when its whole area is afterwards irradiated with ultraviolet ray. As the result, this film functions as a contact mask for the ultraviolet resist of under layer. After development, there can be obtained a fine pattern of good shape in the ultraviolet resist constituting under layer.

That is, the important point of the present invention consists in forming something like a contact mask on ultraviolet resist and thereby preventing the spacial diffraction and scattering of ultraviolet ray and, in addition, transferring the fine pattern resolving power obtained in the first excimer laser irradiation to the ultraviolet resist of under layer.

Here, there is a possibility that, when the upper layer material (a material decreasing its ultraviolet transmittance upon exposure to far ultraviolet ray) is exposed to far ultraviolet ray, the far ultraviolet ray may reach the under layer (ultraviolet resist). However, the ultraviolet resist has an extremely low sensitivity to far ultraviolet ray (for example, sensitivity of ultraviolet resist MP 1400 to KrF excimer laser is 10 $mJ/cm^2$ or more), so that the far ultraviolet ray cannot act upon the ultraviolet resist of under layer and no defective pattern formation can be caused by it.

## BRIEF DESCRIPTION OF THE DRAWINGS

Figures 1 to 3 are sectional views illustrating the steps of one example of the pattern forming method of the present invention, and Figures 4 to 7 are sectional views illustrating the steps of prior pattern forming method; wherein:

1 is substrate, 2 and 8 are resists (MP 1400), 3 and 14 are water-soluble films, 4 is a film of the material of the invention, 5 is mask, 6 is KrF excimer laser, 7 is ultraviolet ray (g line), 9 is photosensitive layer of the invention, 10 is ultraviolet ray (i line), 11 is polyvinyl pyrrolidone film, 12 is a layer of spiropyran compound, 13 is resist (Az 2400), 15 is Acridine Orange film, 16 is ArF excimer laser, and 17 is far ultraviolet resist (MP 2400).

## DETAILED DESCRIPTION OF THE INVENTION

As the upper layer material decreasing its ultraviolet transmittance upon exposure to far ultraviolet ray usable in the invention, mixtures consisting of an azide compound and a phenolic resin can be referred to. The present inventors have discovered that, when this material is exposed to far ultraviolet ray, the azide compound polymerizes with the phenolic resin and thereby decreases its transmittance in the ultraviolet region. Examples of said azide compound include the followings:

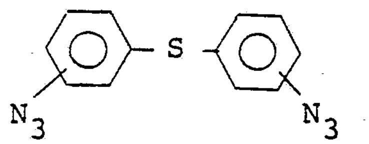 , 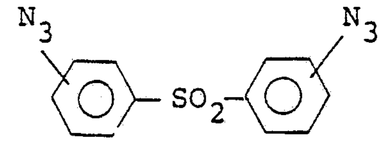 ,

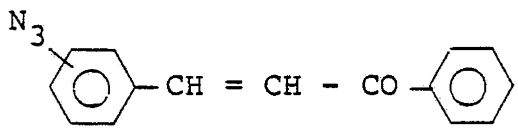 ,

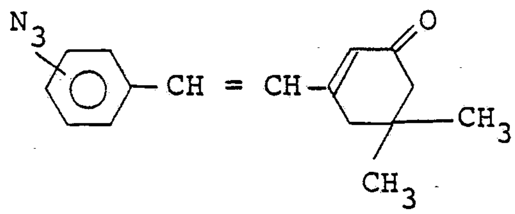 ,

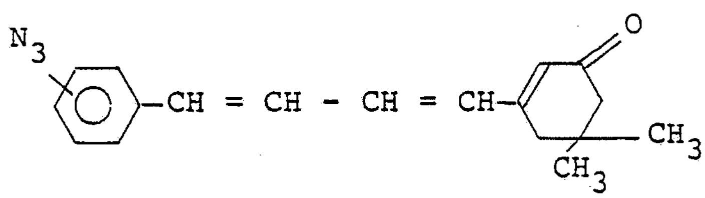 ,

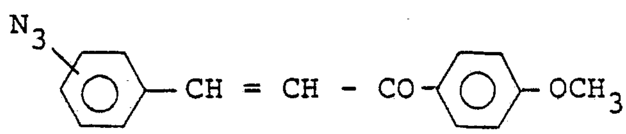

Examples of said phenolic resin include cresol-formaldehyde novolac resin, polyvinylphenol resin, xylenol resin,

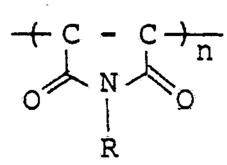

(R is substituent and n is an integer), its copolymers, and the like.

As the water-soluble film of the intermediate layer, those made of pullulan, polyvinyl pyrrolidone, polyvinyl alcohol and the like can be referred to. It is provided for the purpose of preventing the mutual contamination between the upper and under layers, and its thickness is preferably about 0.5 µm or less because it must not cause diffraction of light.

The upper and intermediate layers can be removed by lifting off the water-soluble film of intermediate layer with water or aqueous solution of alkali. If a developing solution for the resist of under layer is used, removal of the upper and intermediate layers and the development of under resist can be practised simultaneously.

As the light source of the first far ultraviolet irradiation, excimer lasers can be referred to. As the light source of the subsequent whole area ultraviolet irradiation, g-line and i-line can be referred to. Needless to

say, these light sources are not limitative.

The intermediate water-soluble film is provided mainly for the purpose of preventing the mutual contamination of upper and under layers. The step for forming the intermediate layer may be omitted, if upper and under layers can be formed without mutual contamination without this step. In this case, the ultimate pattern has a form of double layer.

Further, in order to solve the above-mentioned problems, the invention provides a method for forming a pattern which comprises coating a resist with a photosensitive solution showing a color fading action upon exposure to ultraviolet ray, exposing the coating to excimer laser according to a desired pattern and then developing it.

According to the invention, a pattern of good shape can be formed as mentioned below. Thus, when exposed to high energy beams such as excimer laser, the layer of photosensitive solution showing a color fading action upon exposure to excimer laser decreases its absorption and increases its transmittance in the ultraviolet region. If this is thereafter exposed to ultraviolet ray, the ultraviolet ray is absorbed by the photosensitive solution showing a color fading action upon exposure to ultraviolet ray and cannot reach the resist of under layer in the area through which excimer laser has not passed in the first exposure to excimer laser, while the ultraviolet ray can sensitize the under layer resist in the area through which the excimer laser has passed in the first exposure to excimer laser because of the increased transmittance of the area.

By the subsequent development, the area through which the excimer laser has passed is developed and there is formed a fine pattern of excimer laser.

In the invention, the photosensitive solution showing a color fading action upon exposure to ultraviolet ray contains a compound of which color can fade upon exposure to ultraviolet ray, such as diazo compound, nitron compound or the like. Further, the photosensitive solution is made into a layer by the use of a water-soluble binder polymer such as pullulan, polyvinyl alcohol, polyvinyl pyrrolidone and the like.

Needless to say, the photosensitive solution usable in the invention is not limited to the above-mentioned ones. When the binder polymer is polystyrene or novolac resin and the solvent used therein is an organic solvent, an intermediate layer of water-soluble polymer may be provided on the resist before coating it with the photosensitive solution, for the purpose of preventing the resist from contamination with the solvent.

In order to solve the problems in the prior pattern forming methods, the present inventoin provides a pattern forming method which comprises forming a layer of spiropyran compound on an ultraviolet-sensitive resist, selectively exposing it to far ultraviolet ray, thereafter exposing the whole area to ultraviolet ray, and then developing it to form a pattern.

The spiropyran compound of the present invention shows a great ultraviolet absorption, and its absorption in ultraviolet region becomes smaller (transmittance becomes greater) after exposure to far ultraviolet ray. Accordingly, if it is selectively exposed to far ultraviolet ray, only the unexposed area in the spiropyran compound-containing layer can be formed into a mask for ultraviolet ray. Therefore, if its whole area is subsequently exposed to ultraviolet ray, only the area of resist just under the exposed area to far ultraviolet ray is sensitized and it can be dissolved off upon development. As the result, the negative area in the first selective exposure to far ultraviolet ray remains as a pattern to give a positive type pattern. Since the ultraviolet-sensitive resist of the invention is sufficiently low in sensitivity to the light having passed through the upper spiropyran compound-containing layer because it is an ultraviolet resist, it causes no defect in pattern at all.

As above, according to the invention, an exposure quite resembling a contact exposure can be realized on the resist, so that a fine pattern of good shape can be produced by the exposure using far ultraviolet ray.

As said far ultraviolet ray, excimer lasers of XeCl, KrF, ArF and the like can be used. As said ultraviolet ray, g-line (436 nm), i-line (365 nm) and the like can be used.

The spiropyran compound-containing layer can be prepared in the following manner. Thus, when the spiropyran compound is water-soluble, it may be formed into a film by dissolving it into a water-soluble polymer such as polyvinyl pyrrolidone, pullulan, polystyrene-sulfonic acid, polyvinyl alcohol, ammonium polystyrene-sulfonate and the like. When it is insoluble in water, its film may be formed by dissolving it into general resin (e.g. novolac resin, polyvinylphenol resin, poly(styrene-maleic acid) copolymer resin, poly-(styrene-maleic half ester) copolymer resin, and the like or mixtures thereof) and providing the dissolved mixture onto a water-soluble polymer film having been prepared in the above-mentioned manner. In any of these cases, the spiropyran compound-containing layer is removed at the time of development.

As said spiropyran compound, any spiropyran compound may be used so far as its ultraviolet transmittance can be improved upon exposure to far ultraviolet ray. For example, a compound represented by the following formula:

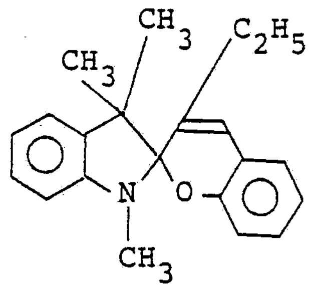

can be used.

Further, in order to solve the aforementioned problems, the present invention provides a method which comprises forming, as an upper layer of resist, a film containing an acridine derivative through intermediation of a water-soluble intermediate layer, pattern-wise exposing it to ArF excimer laser and then irradiating the whole area with far ultraviolet ray such as KrF excimer laser or the like.

According to the method of the invention, a fine pattern of good shape can be formed. Thus, the acridine derivative greatly increases its absorption at about 250 nm upon exposure to ArF excimer laser (absorbance increases up to about 100 times the original value). Accordingly, the area exposed to ArF excimer laser hardly passes the subsequently projected far ultraviolet ray, while the area unexposed to KrF excimer laser passes the far ultraviolet ray and allows it to reach the bottom part of under layer resist. As the result, the first produced ArF laser-exposed area is transferred to the under layer resist to remain there as a pattern. Since the light reaches the bottom of under layer resist as above, a pattern of good shape can be obtained by the use of ArF excimer laser according to the method of invention.

Next, examples of the invention will be presented.

Example 1

Referring to Figure 1, the steps constituting one example of the pattern forming method of the invention will be explained.

On substrate 1 of semiconductor or the like which had been made hydrophobic by a treatment, an ultraviolet resist MP 1400 (manufactured by Shipley Co.) was coated up to a thickness of 1.2 µm and pre-baked at 90 °C for 2 minutes to prepare resist film 2 (Figure 1a).

Next, a 10% aqueous solution of pullulan (molecular weight 40,000, manufactured by Hayashibara Seibutsu Kagaku Kenkyusho) was coated thereon to prepare a film 3 having a thickness of 0.2 µm. Over this layer, a material of the invention having the following formulation was coated and baked in oven at 80 °C for 20 minutes to prepare film 4 having a thickness of 0.5 µm (Figure 1b).

| | |
|---|---|
| 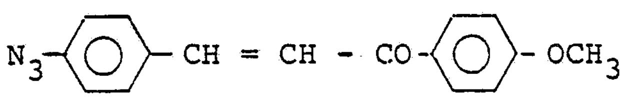 | 3 g |
| Polyvinylphenol resin | 10 g |
| Cyclohexanone | 58 g |

Then, via mask 5, KrF excimer laser 6 (NA 0.35) was selectively irradiated in a quantity of 250 $mJ/cm^2$ (Figure 1c). By this irradiation, the exposed area 40 decreased its ultraviolet transmittance. Then, g-line 7 (436 nm) as an ultraviolet ray was irradiated onto the whole area in a quantity of 250 $mJ/cm^2$. At this time, exposed area 40 functioned as a contact mask for resist film 2. Then, intermediate layer 3 and upper layer film 4 were removed with 2.4% alkaline aqueous solution of tetramethylammonium hydroxide (Figure 1e). Finally, it was developed with alkaline developing solution MF 319 (manufactured by Shipley Co.) to remove the area 20, having been exposed to ultraviolet ray 7, of resist 2 to obtain a pattern (Figure 1f). The resist pattern 2A thus obtained was a sharp 0.4 µm line-and-space pattern having an aspect ratio of 90°.

In another experiment, the above-mentioned procedure is repeated, except that the material of the

invention is replaced with RU-1100N (a commercially available mixture of azide compound and phenolic resin, manufactured by Hitachi Kasei K.K.). The results obtained is as good as above.

As has been mentioned above, acccrding to the pattern forming method of the invention, the film of the upper layer material decreasing its ultraviolet transmission upon exposure to far ultraviolet ray decreases its ultraviolet transmission in the exposed area upon the selective exposure to excimer layer so that it does not transmit ultraviolet ray at the time of subsequent whole area exposure to ultraviolet ray. As the result, this film functions as a contact mask for the ultraviolet resist of under layer, and development can give a fine pattern of good shape in the ultraviolet resist of the under layer.

Example 2

An ultraviolet resist (MP 1400, manufactured by Shipley Co.) was coated onto substrate 1 such as semiconductor to obtain a resist film 8 having a thickness of 1.5µm (Figure 2a). Then, it was coated with a photosensitive solution 9 of the following formulation, showing a color fading action upon exposure to ultraviolet ray, up to a thickness of 0.3 µm (Figure 2b).

| | |
|---|---|
| 4-Diaminobenzenediazonium sulfate | 5 g |
| 10% (by weight) aqueous solution of pullulan | 25 g |

Via mask 5, it was irradiated with KrF excimer laser 6 (Figure 2c). In the irradiated area 90, transmittance of the photosensitive layer 9 to excimer laser 6 was 98% at 365 nm. On the other hand, in the area not irradiated with the excimer laser, the transmittance was 5% at 365 nm. Subsequently, the whole area was irradiated with i-line 10 (365 nm, ultraviolet ray). At this time, the irradiated part 90 functioned as a contact mask (Figure 2d). Then, the photosensitive layer 9 was removed with alkaline developing solution MF 314 (manufactured by Shipley Co.) and at the same time development of resist 1 was carried out, whereby a part of resist 8, irradiated with i-line 10, was removed to obtain pattern 8A (Figure 2e). Pattern 8A was a good, sharp, 0.4 µm pattern having an aspect ratio of 86° or above.

As above, according to the method of this example, the layer of photosensitive solution showing a color fading action upon exposure to ultraviolet ray decreases its ultraviolet absorption and increases its transmittance when irradiated with excimer laser. If it is subsequently exposed to ultraviolet ray, the ultraviolet ray is absorbed into the layer of photosensitive solution showing a color fading action upon exposure to ultraviolet ray and cannot reach the under layer resist, in the area through which the excimer laser has not passed. On the other hand, in the area through which the excimer laser has passed, transmittance of photosensitive solution layer is improved, so that the ultraviolet ray can reach and sensitize the under layer resist.

As the result, a subsequent development can develop the area through which excimer laser has passed, and there is formed a fine pattern according to the shape of the excimer laser.

Example 3

Referring to Figure 3, the pattern forming method of the invention will be explained. A positive resist 2 (MP 1400, manufactured by Shipley Co.) sensitive to ultraviolet ray was formed on substrate 1 such as semiconductor up to a thickness of 1.2 µm (Figure 3a). Then, it was coated with 10% aqueous solution of polyvinyl pyrrolidone to obtain film 11 having a thickness of 0.2 µm. Over it, a solution of the following formulation was coated to obtain film 12 having a thickness of 0.35 µm:

Novolac resin (meta:para = 4:1, MW 5,000) 5.0 g

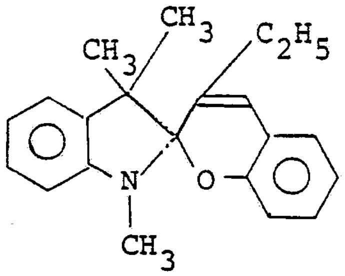

3.5 g

Diethylene glycol dimethyl ether 42.0 g

(Figure 3b). Then, it was exposed to light 6 with NA 0.36 KrF excimer laser stepper via mask 5. As the result, the exposed part 120 of film 12 increased its transmittance to ultraviolet ray (g-line) (Fiugure 3c). Then, g-line 7 was irradiated to the whole area at a rate of 150 mJ/cm$^2$. At this time, the exposed part 120 functioned as a contact mask for g-line 7 (Figure 3d). Finally, the above-mentioned water-soluble film was lifted off and the film containing the spiropyran compound was removed by puddling it with MF 319 developing solution (manufactured by Shipley Co.) for 60 seconds. Thus, the g-line-irradiated part of the resist was removed (development) to form pattern 2A′ (Figure 3e). The pattern 2A′ thus obtained was a 0.5 µm line-and-space pattern entirely free from film loss and having an aspect ratio of 88°.

As above, the spiropyran compound such as mentioned in this example shows a great ultraviolet absorption before exposure to far ultraviolet ray and a small ultraviolet absorption (great transmittance) after exposure to far ultraviolet ray. Accordingly, if the resist is selectively exposed to far ultraviolet ray, only the unexposed part containing spiropyran compound functions as a mask for ultraviolet ray. If the whole area is subsequently irradiated with ultraviolet ray, only the resist just under the far ultraviolet ray-exposed part is sensitized and dissolved away upon development, as the result of which there is obtained a positive type resist pattern in which only the negative area in the first selective exposure to far ultraviolet ray remains as a pattern. Since the ultraviolet-sensitive resist of the invention is an ultraviolet resist, its sensitivity is sufficiently low to the far ultraviolet ray passing through the spiropyran-containing upper layer upon exposure to far ultraviolet ray. Accordingly, it is entirely free from pattern defect caused by the light having passed through the spiropyran compound-containing layer.

As above, according to the invention, a contact exposure can be carried out on resist, and therefore a fine pattern of good shape can be formed according to the shape of far ultraviolet ray.

Example 4

Referring to Figure 4, another embodiment of the pattern forming method of the invention will be illustrated below. A positive type resist AZ 2400 was rotationally coated onto substrate 1 such as semiconductor and pre-booked to obtain a 1.5 µm resist 13 (Figure 4a). Then, 10% aqueous solution of pullulan was coated thereon to prepare film 14 having a thickness of 0.3 µm as an intermediate layer (Figure 4b). Then, a photosensitive material composed of 1 g of Acridine Orange, 10 g of p-cresol novolac resin and 50 g of diethylene glycol dimethyl ether was rotationally coated thereon to prepare an acridine film 15 having a thickness of 0.2 µm (Figure 4c). Thereafter, it was selectively exposed to ArF excimer laser 6 via mask 5 (Figure 4d), whereby the exposed area 150 decreased its transmittance to KrF excimer laser. Then, its whole area was irradiated with KrF excimer laser 6 (Figure 4e). At this time, the exposed area 150 functioned as a contact mask. Finally, the intermediate film 12 and the Acridine Orange film 15 were removed and at the same time the resist 13 was developed by a treatment using an alkaline developing solution (MF 2401, 20%, manufactured by Shipley Co.) for 60 seconds, whereby the laser (6)-irradiated part was removed (Figure 4f). The resist pattern 13A thus obtained was 0.4 µm line-and-space pattern having so good a contrast as 87°.

Although light slightly reaches the under layer resist at the time of exposure to Arf excimer laser, this makes no trouble because usual resists are very low in sensitivity to ArF laser. The acridine derivative film of this example can be prepared by mixing about 10% by weight of acridine derivative into novolac resin or styrene resin, dissolving the mixture into a solvent such as diethylene glycol dimethyl ether and the like,

and spin coating it. Although the absorbance after the exposure to ArF laser varies depending on the amount of acridine derivative, the present inventors have revealed that an amount of about 10% by weight of acridine derivative based on the weight of above-mentioned resin is enough for the purpose from the viewpoint of masking at the time of subsequent exposure to far ultraviolet ray. Needless to say, said amount (% by weight) is not limitative.

As the intermediate layer, any substance can be used so far as it is a water-soluble polymer. Apart from the above-mentioned one, polyvinyl alcohol, polyvinyl pyrrolidone and the like are also usable. Further, a similar effect to above can be obtained by using Acridine Red, Acridine Yellow and the like or their mixture in place of Acridine Orange, too.

As has been mentioned above, the present invention is characterized by solving the aforementioned problems by forming a film containing an acridine derivative on a resist through intermediation of a water-soluble intermediate layer, exposing it to ArF excimer laser pattern-wise and thereafter irradiating its whole area with far ultraviolet ray (KrF excimer laser or the like).

According to the method of the present invention, a fine pattern of good shape can be formed. That is to say, acridine derivative much increases its absorption near 250 nm upon exposure to ArF laser (absorbance becomes about 100 times the initial value). Therefore, the area exposed to ArF excimer laser hardly passes far ultraviolet ray in the subsequent step, while the area unexposed to ArF laser passes far ultraviolet ray and allows it to reach the bottom part of the under layer resist. As the result, the shape of the first ArF laser-exposed part is transferred to the under layer resist and remains as a pattern. Since the light reaches the bottom of under layer resist as above, a pattern of good shape can be formed by the use of ArF excimer laser according to the invention.

## Claims

1. A pattern forming method which comprises forming a positive type resist sensitive to ultraviolet ray on a substrate, forming thereon a water-soluble film, forming further thereon a film of a material decreasing its ultraviolet transmittance upon exposure to far ultraviolet ray, selectively exposing it to far ultraviolet ray, further exposing the whole area to ultraviolet ray, then removing said water-soluble film and said film of a material decreasing its ultraviolet transmittance upon exposure to far ultraviolet ray and developing the positive type resist to form a pattern of the resist.

2. A method according to Claim 1, wherein said water-soluble film is prepared from pullulan, polyvinyl pyrrolidone, polyvinyl alcohol or a combination thereof.

3. A method according to Claim 1, wherein the formation of said water-soluble film on the positive type resist is omitted.

4. A method according to Claim 1, wherein said material decreasing its ultraviolet transmittance upon exposure to far ultraviolet ray comprises an azide compound and a phenolic resin.

5. A method according to Claim 1, wherein said ultraviolet ray is g-line (436 nm) or i-line (365 nm).

6. A method according to Claim 1, wherein said water-soluble film and said film of a material decreasing its ultraviolet transmittance upon exposure to far ultraviolet ray are removed by the use of an alkaline developing solution.

7. A pattern forming method which comprises a step for forming an ultraviolet-sensitive resist on a substrate, a step for coating a photosensitive solution showing a color-fading action upon exposure to ultraviolet ray on said resist film, a step for exposing it to far ultraviolet ray according to a desired pattern, a step for irradiating its whole surface with ultraviolet ray and a step of development for forming a pattern of the resist.

8. A method according to Claim 7, wherein said photosensitive solution showing a color fading action upon exposure to ultraviolet ray contains a compound having diazo group or nitron group.

9. A method according to Claim 7, wherein said far ultraviolet ray is a light oscillated from an excimer laser.

10. A pattern forming method which comprises forming an ultraviolet-sensitive resist on a substrate, forming thereon a layer containing a spiropyran compound, selectively exposing it to far ultraviolet ray, subsequently exposing its whole area to ultraviolet ray, and then developing the resist to form a pattern.

11. A method according to Claim 10, wherein said spiropyran compound increases its ultraviolet transmittance upon exposure to far ultraviolet ray.

12. A method according to Claim 10, wherein said far ultraviolet ray is an excimer laser of XeCl, KrF or ArF.

13. A method for forming a pattern on a semiconductor device which comprises a step for coating a resist onto a substrate, a step for forming a water-soluble film, a step for forming a film containing an acridine derivative, a step for selectively exposing it to ArF excimer laser, a step for irradiating the whole area with far ultraviolet ray, and a step for removing said water-soluble film and said film containing an acridine derivative and, at the same time, for developing said resist with an alkaline developing solution.

14. A method according to Claim 13, wherein said acridine derivative is one of Acridine Yellow, Acridine Orange and Acridine Red or a mixture thereof.

15. A method according to Claim 13, wherein said far ultraviolet ray is KrF excimer laser.

FIG. 1(a)

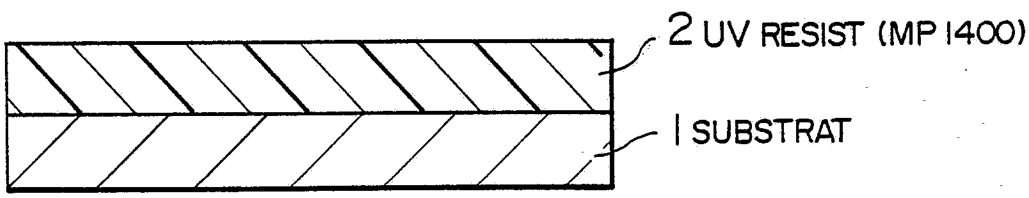


FIG. 1(b)

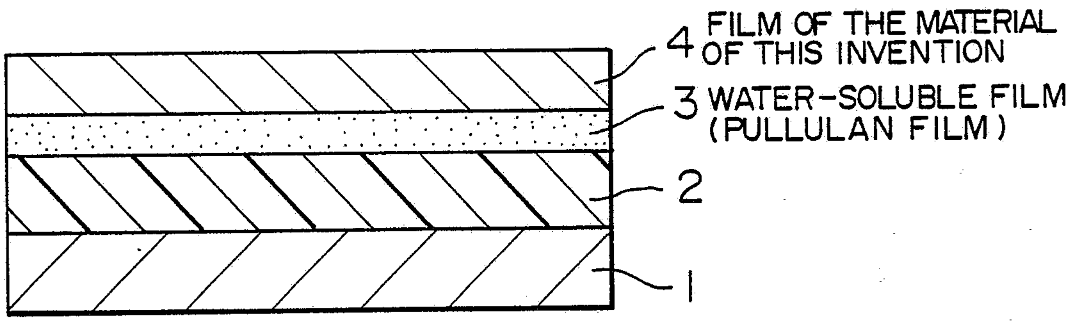


FIG. 1(c)

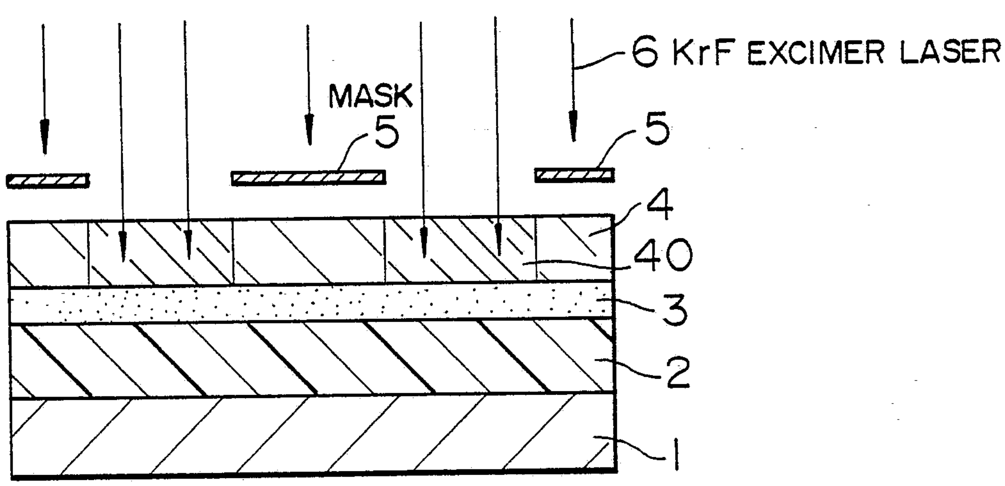

FIG. 1(d)

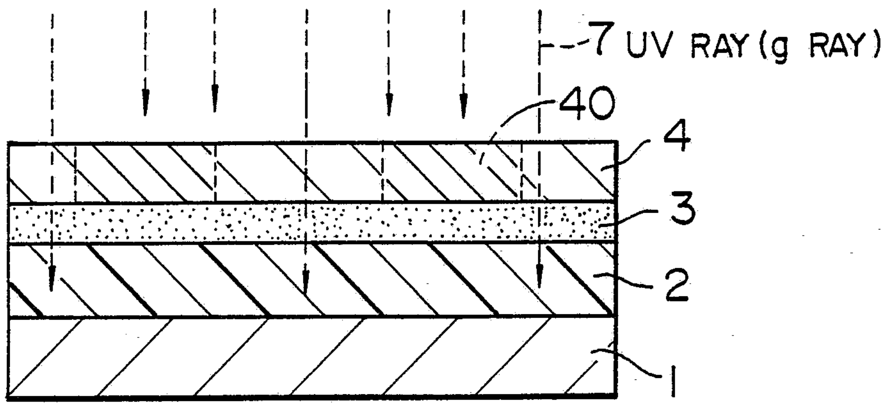


FIG. 1(e)

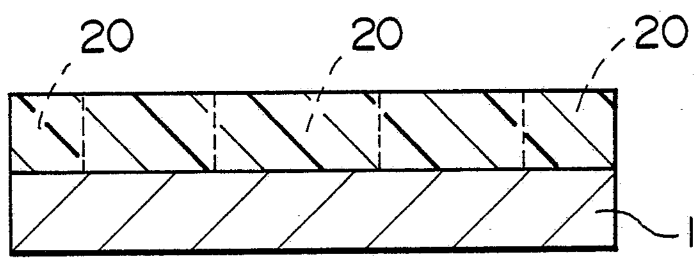


FIG. 1(f)

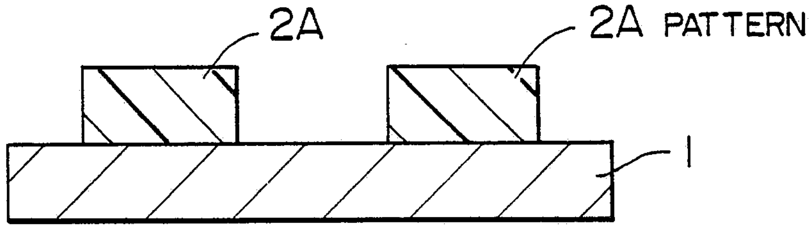

FIG. 2(a)

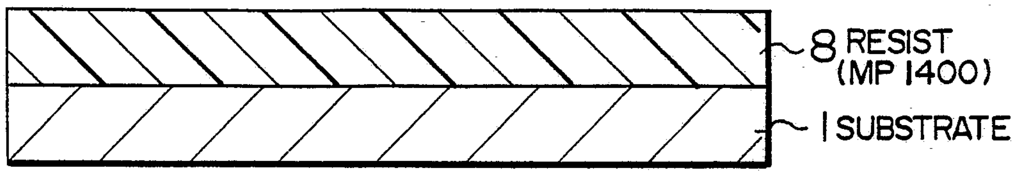


FIG. 2(b)

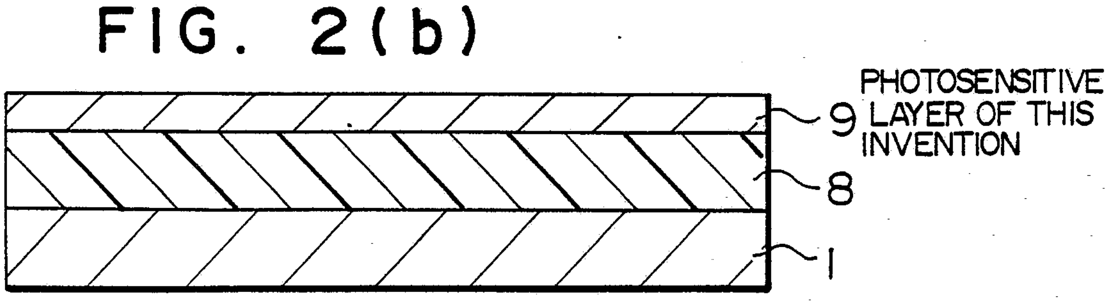


FIG. 2(c)

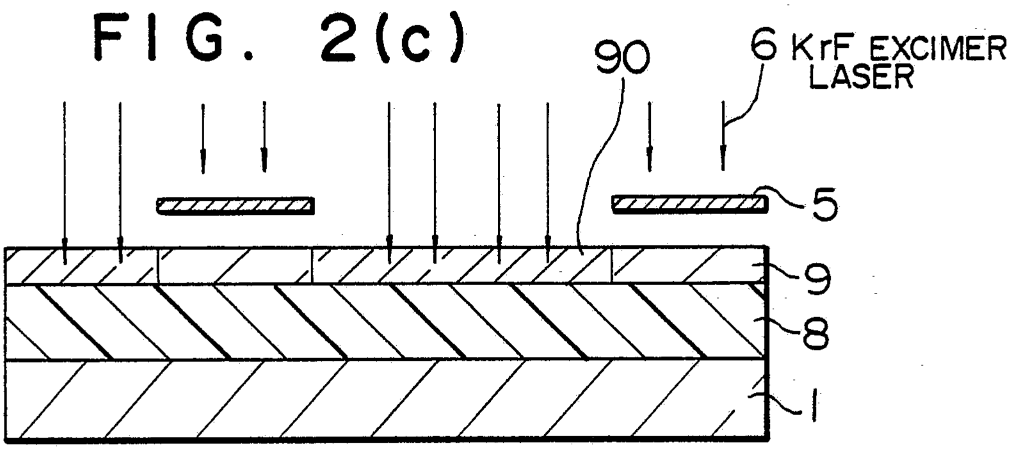


FIG. 2(d)

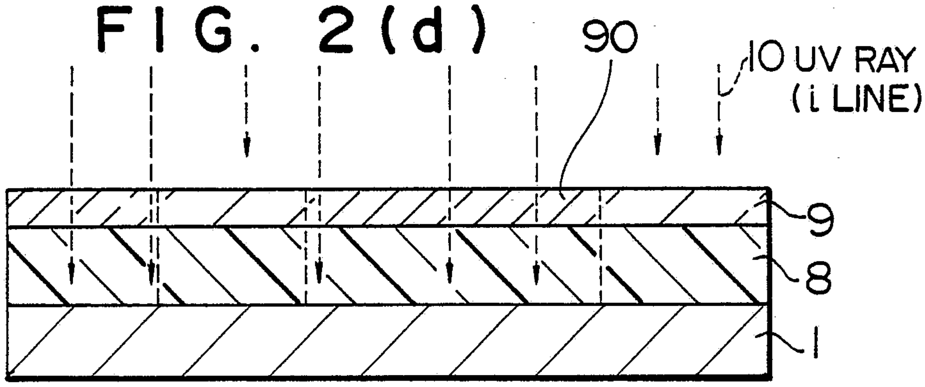


FIG. 2(e)

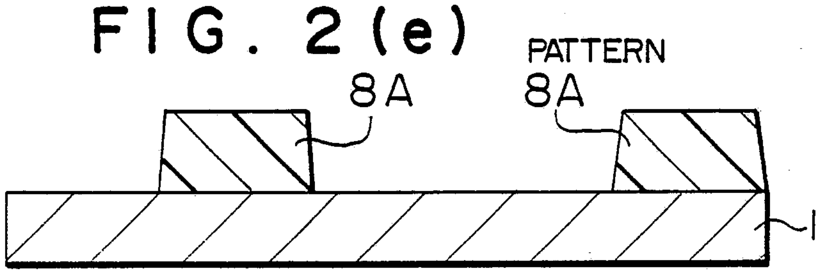

FIG. 3 (a)

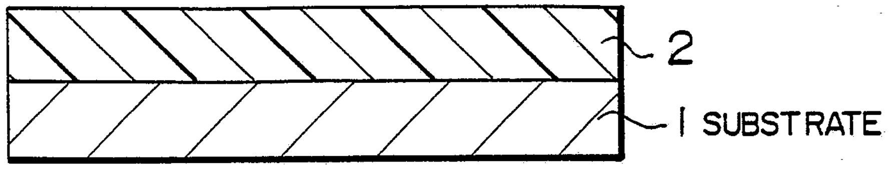


FIG. 3 (b)

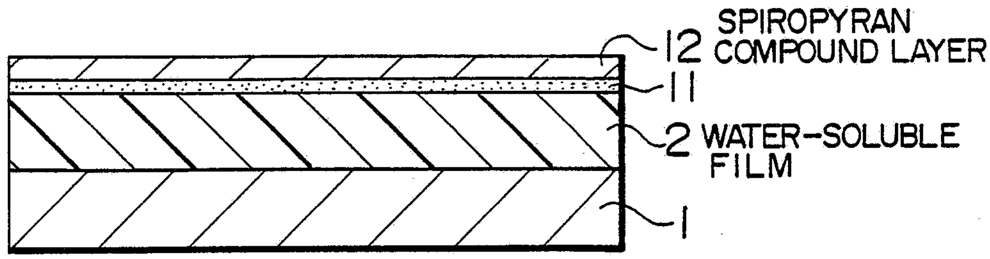


FIG. 3(c)

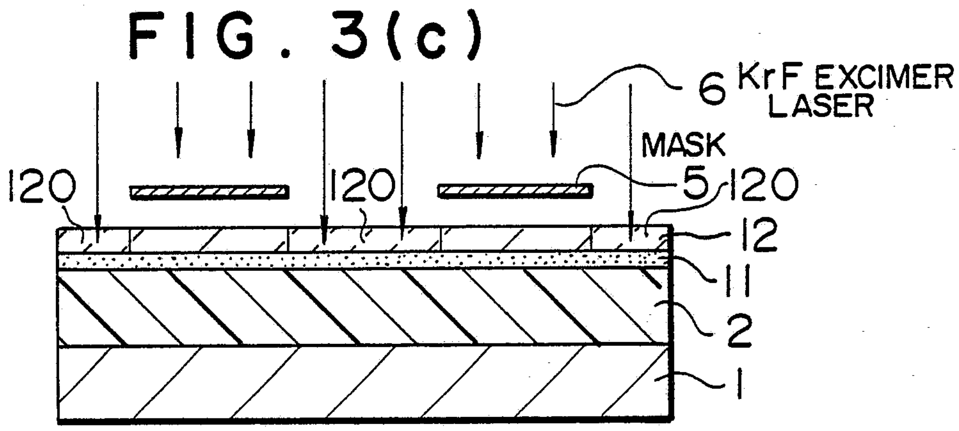


FIG. 3(d)

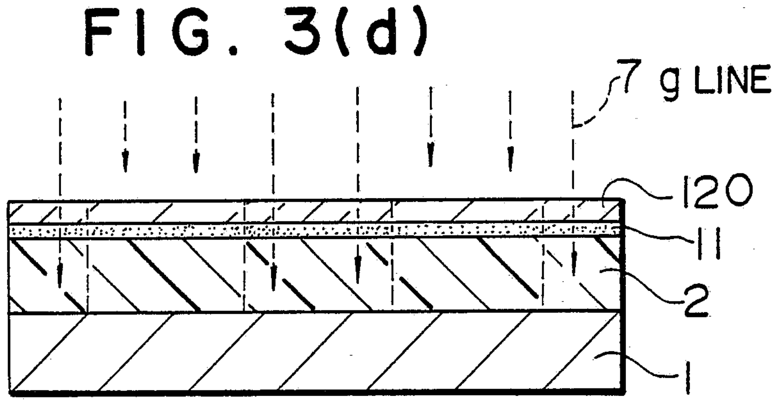


FIG. 3(e)

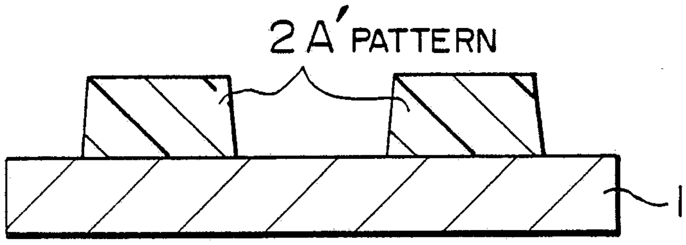

FIG. 4(a)

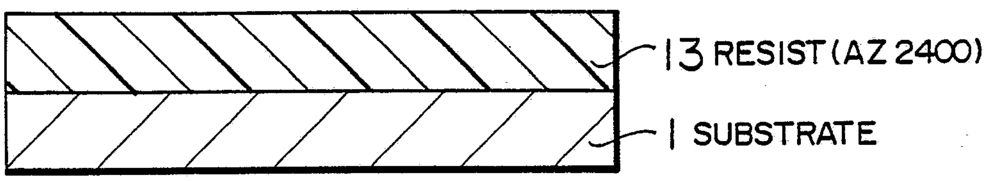


FIG. 4(b)

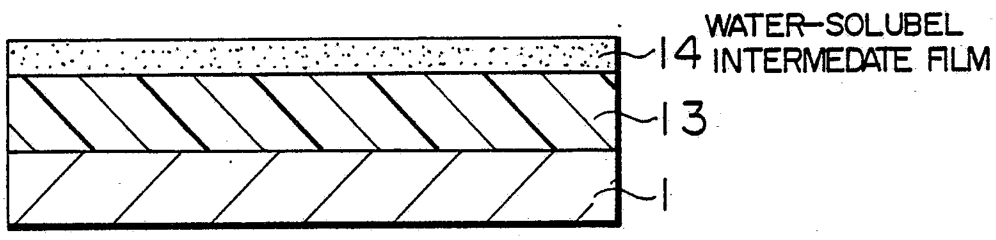


FIG. 4(c)

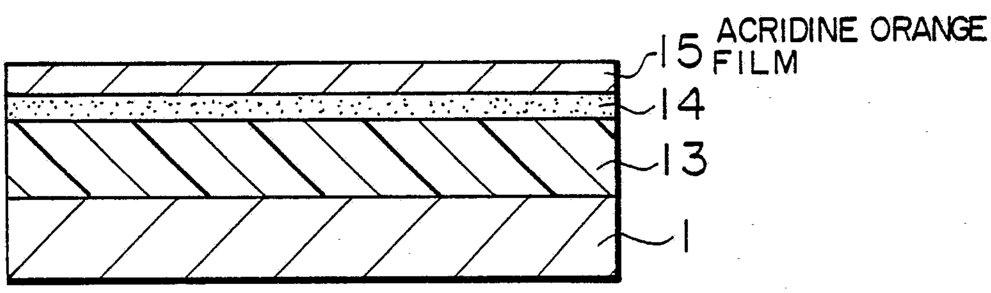

FIG. 4(d)

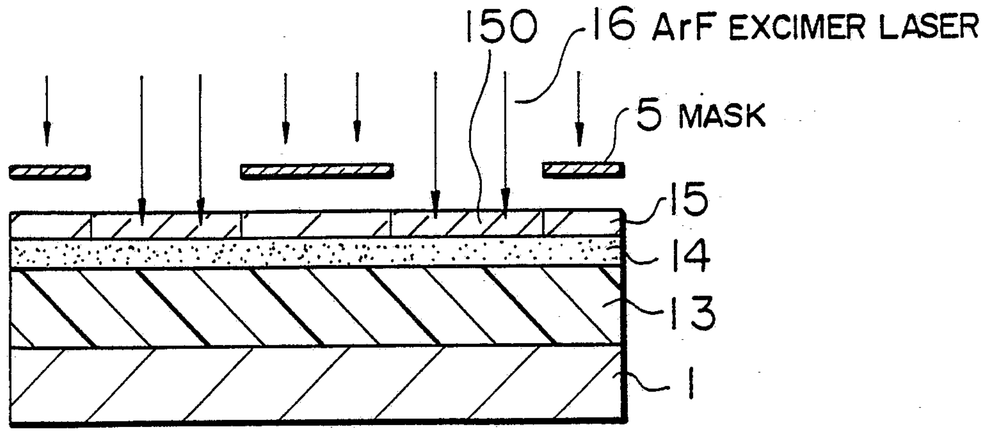


FIG. 4(e)

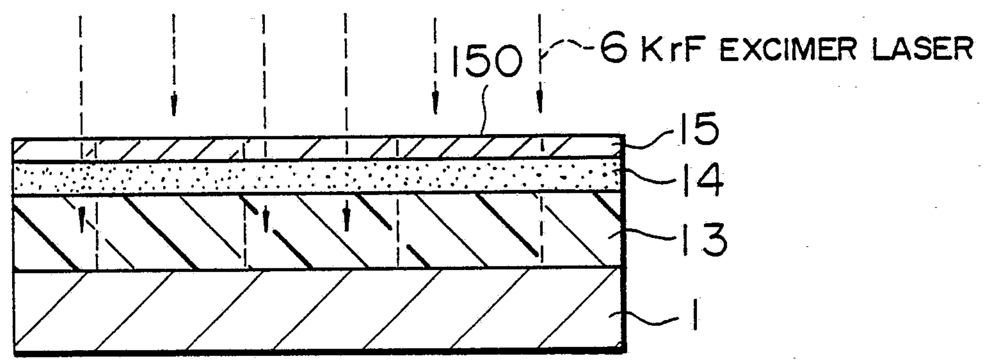


FIG. 4(f)

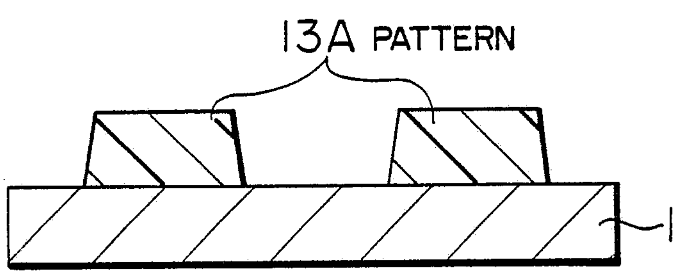

FIG. 5(a)
PRIOR ART

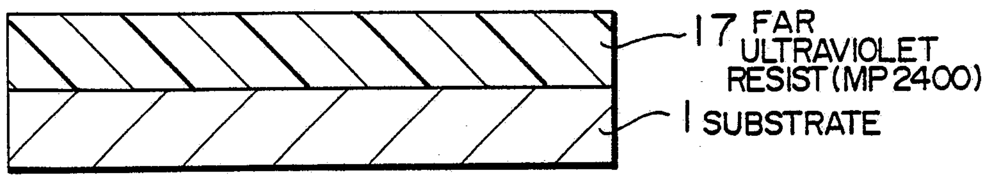


FIG. 5(b)
PRIOR ART

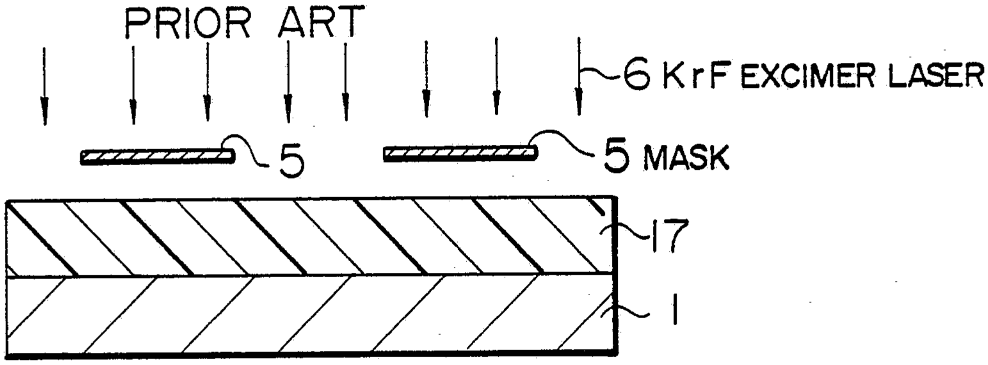


FIG. 5(c)
PRIOR ART

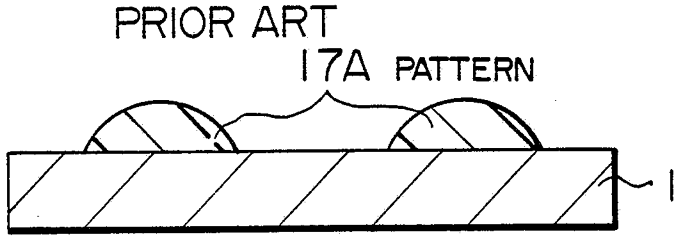

FIG. 6(a)
PRIOR ART

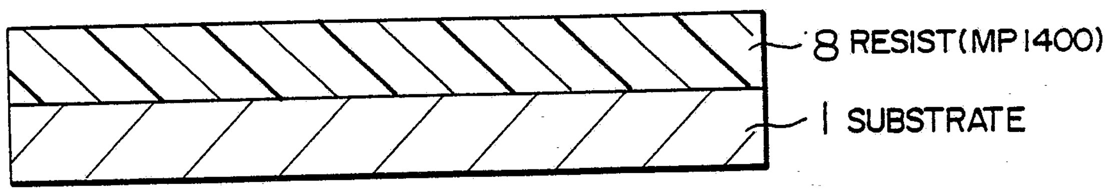


FIG. 6(b)
PRIOR ART

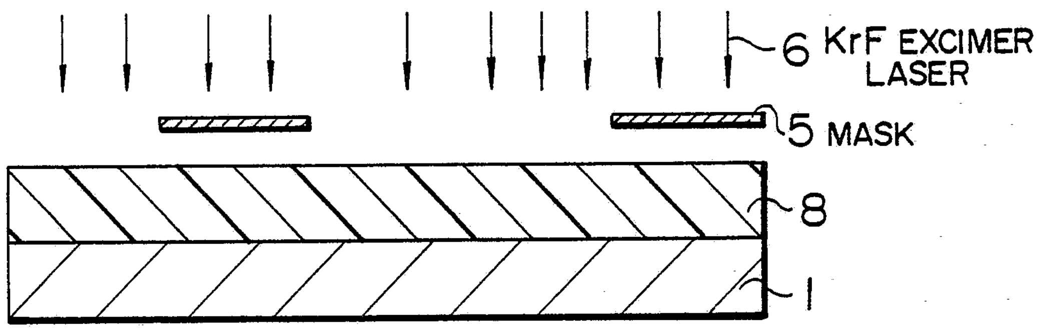


FIG. 6(c)
PRIOR ART

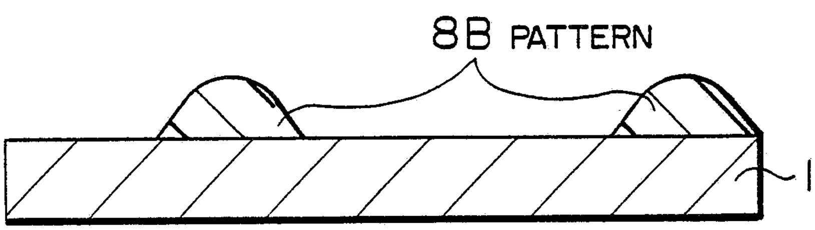

FIG. 7(a)
PRIOR ART

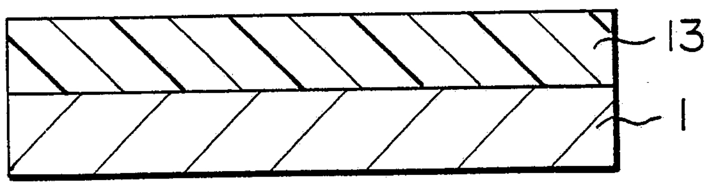


FIG. 7(b)
PRIOR ART

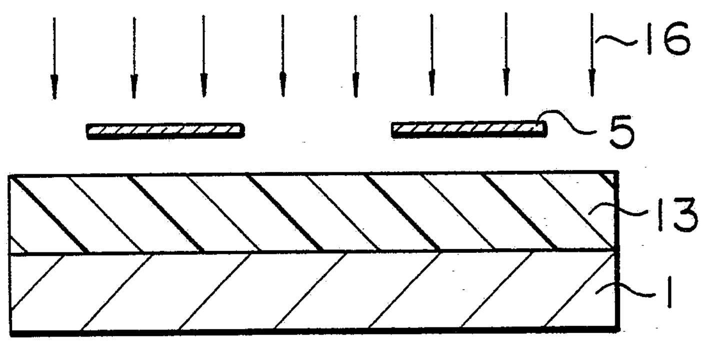


FIG. 7(c)
PRIOR ART

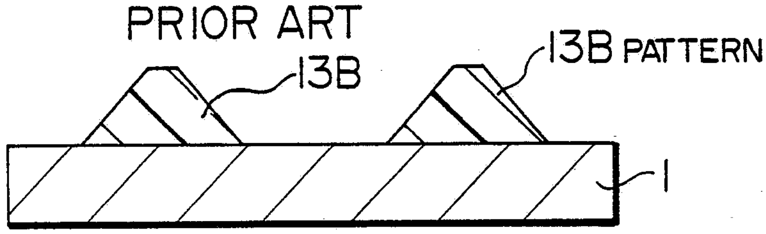

European Patent Office

# EUROPEAN SEARCH REPORT

Application Number

EP 88 11 7505

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 182 332 (HEWLETT PACKARD CO.) * pages 4,5,8; figures 1-4; claims 1-3,6 * | 7,9 | H 01 L 21/00<br>G 03 F 7/08 |
| Y | | 8,10,13 | |
| A | | 1,3,12,15 | |
| X | EP-A-0 192 302 (N.V. PHILIPS) * columns 1,2; claims 1-4,10-12; figures 1-4 * | 7 | |
| A | | 1,3,4,10,13 | |
| Y | US-A-3 982 943 (B.C. FENG et al.) * column 2, line 49 - column 3, line 12; column 3, line 62 - column 4, line 67; claims 1,3; figures 1a-1g * | 13 | |
| A | | 1,6 | |
| Y | PATENT ABSTRACTS OF JAPAN vol. 11, no. 4 (E-468)(2451), 7th January 1987; & JP - A - 61 179 535 (MATSUSHITA ELECTRIC CO. LTD.) 12-08-86 * abstract * | 8 | **TECHNICAL FIELDS SEARCHED (Int. Cl.4)** |
| A | idem | 1,12 | H 01 L 21/00<br>G 03 F 7/00 |
| Y | PATENT ABSTRACTS OF JAPAN vol. 6, no. 135 (C-115)(1013), 22nd July 1982; & JP - A - 57 59956 (SONY K.K.) 10-04-1982 * abstract * | 10 | |
| A | idem | 11 | |

-/-

The present search report has been drawn up for all claims

| Place of search | Date of completion of the search | Examiner |
|---|---|---|
| BERLIN | 23-01-1989 | KLOPFENSTEIN P R |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent Office

# EUROPEAN SEARCH REPORT

Application Number

EP 88 11 7505

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN vol. 6, no. 162 (P-137)(1040), 25th August 1982; & JP - A - 57 81261 (TOUKIYOU OUKA KOGYO) 21-05-1982 * abstract * --- | 4 | |
| A | JOURNAL OF INFORMATION RECORDING MATERIALS vol. 15, no. 2, 1987, pages 75-87, Berlin, DDR; D. KREYSIG: "Neue Trends in der Entwicklung, Anwendung und Verarbeitung organischer Photoresiste" * pages 84,85; figure 4 * ----- | 1,3,7, 10,13 | |
| | | | TECHNICAL FIELDS SEARCHED (Int. Cl.4) |

The present search report has been drawn up for all claims

| Place of search | Date of completion of the search | Examiner |
|---|---|---|
| BERLIN | 23-01-1989 | KLOPFENSTEIN P R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)